# EUROPEAN PATENT SPECIFICATION

(11) **EP 2 424 106 B1**
(45) Date of publication and mention of the grant of the patent: **20.06.2018**
(21) Application number: 11173792.0
(22) Date of filing: 13.07.2011
(51) Int. Cl.: H03F 3/30, H03F 3/343, H03F 1/34, H03F 1/52

(54) **Amplifying circuit**
Verstärkungsschaltung
Circuit amplificateur

(30) Priority: 27.08.2010 JP 2010191453; 31.05.2011 JP 2011121134
(43) Date of publication of application: 29.02.2012
(73) Proprietor: Onkyo Corporation, Neyagawa-shi, Osaka 572-8540 (JP)
(72) Inventor: Kawaguchi, Tsuyoshi, Osaka, Osaka 572-8540 (JP); Kitagawa, Norimasa, Osaka, Osaka 572-8540 (JP); Sekiya, Mamoru, Osaka, Osaka 572-8540 (JP); Shimasaki, Naofumi, Osaka, Osaka 572-8540 (JP)
(74) Representative: Horn Kleimann Waitzhofer Patentanwälte PartG mbB

(56) References cited:
- WO-A1-98/08302
- WO-A1-2005/114832
- GB-A- 2 266 021
- JP-A- 2010 035 117
- US-A- 3 448 395
- US-A1- 2005 024 143
- LIDGEY J ET AL: "Current-mode analogue signal processing", BIPOLAR CIRCUITS AND TECHNOLOGY MEETING, 1991., PROCEEDINGS OF THE 199 1 MINNEAPOLIS, MN, USA 9-10 SEPT. 1991, NEW YORK, NY, USA,IEEE, US, 9 September 1991 (1991-09-09), pages 224-232, XP010048591, DOI: 10.1109/BIPOL.1991.160993 ISBN: 978-0-7803-0103-0

## Description

### BACKGROUND OF THE INVENTION

### 1. Field of the Invention

The present invention relates to an amplifying circuit with a bias circuit.

### 2. Description of the Related Art

In general current feedback amplifiers, a PNP transistor and an NPN transistor are provided in an input stage, and an input signal is supplied to a base of the PNP transistor and a base of the NPN transistor. A collector of the PNP transistor is connected to a negative power source, and a collector of the NPN transistor is connected to a positive power source. An emitter of the PNP transistor is connected to the positive power source via a first bias circuit (first constant current circuit), and an emitter of the NPN transistor is connected to the negative power source via a second bias circuit (second constant current circuit). Thus, in general current feedback amplifiers, since a plurality of bias circuits composed of constant current circuits should be provided, a number of parts increases, and a circuit configuration becomes complicated.

WO 2005/114832 discloses a circuit for a power amplifier including a main amplifier stage having an operational amplifier (110), a buffer NPN transistor (126) and an NPN transistor (127) connected in a totem pole configuration, and a buffer PNP transistor (133) and a PNP transistor connected in a totem pole configuration. The transistors regulate the voltage to the components directly connected to the operational amplifier (110). A sampling resistor (137) located between a speaker (140) and an output of the power amplifier measures the current. The sampling resistor (137) is inside a negative feedback loop so that an output resistance will be near zero. A protection circuit includes a high common mode rejection difference amplifier that level shifts the sampling resistor voltage to a ground reference voltage. A precision rectifier full wave rectifies the current signal so that the current signal can be compared to a maximum current. If the instantaneous a circuit for a power amplifier includes a main amplifier stage having an operational amplifier, a buffer NPN transistor and an NPN transistor connected in a totem pole configuration, and a buffer PNP transistor and a PNP transistor connected in a totem pole configuration. The transistors regulate the voltage to the components directly connected to the operational amplifier. A sampling resistor located between a speaker and an output of the power amplifier measures the current. The sampling resistor is inside a negative feedback loop so that an output resistance will be near zero. A protection circuit includes a high common mode rejection difference amplifier that level shifts the sampling resistor voltage to a ground reference voltage. A precision rectifier full wave rectifies the current signal so that the current signal can be compared to a maximum current. If the instantaneous current exceeds the maximum current, the protection circuit turns off both the positive and negative power supplies.

US Patent No. 3,448,395 discloses a network for preventing simultaneous conduction in two networks responsive to input signals of opposite polarity comprising in combination an input terminal means; an output terminal means; a first network intermediate to input and output terminal means and adapted to assume a conductive state for positive input signals and provide a responsive output signal at the output terminal means; a second network intermediate the input and output terminal means and adapted to assume a conductive state for negative input signals and provide a responsive output signal at the output terminal means; a sensing means for sensing the polarity of the output signal at the output terminal means, the sensing means including a pair of transistor stages of which one is biased to assume a conductive state and provide a sensing signal when the output signal is positive and the other biased to assume a conductive state and provide a sensing signal when the output signal is negative; and gating means associated with the first network and second network, the gating means adapted for receiving said sensing signals and placing the first network in a non-conductive state when said sensing signals indicate an output signal of one polarity and the second network in a non-conductive state when said sensing signals indicate an output signal of the other polarity.

WO 98/08302 discloses a amplifier circuit comprising an input transistor and an amplifying transistor of opposite type in which the emitter terminal of the input transistor is connected to the base terminal of the second transistor; the amplifier circuit including a balancing circuit which maintains a current balance through the first and second transistors such that the base-emitter potentials of the first and second transistors are held substantially equal to one another. The balancing circuit ensures close equalization of the input voltage and the emitter voltage of the second transistor for all operating regimes of the amplifier.

JP 2010-035117A discloses a current feedback amplifier that amplifies an audio signal configured so as to compose an amplifier circuit that amplifies and audio signal, and a feedback circuit for an audio signal and a feedback circuit for a direct current component independently of each other in order to improve the quality of the audio signal output from the amplifier circuit, and to have a signal path simplified by eliminating a complicated signal path.

Lidgey, J. et al discloses in Current-mode analogue signal processing", IEEE 1991 Bipolar Circuits and Technology Meeting 10.1, an overview of current-mode analogue signal processing, in particular voltage-mode op-amps extended to provide current-mode performance.

US 2005/024143 A1 discloses a device which uses two transistors connected with the collector of a first transistor connected to the base/gate of a second transistor and the base of the first transistor connected to the emitter/source of the second transistor.

### SUMMARY OF THE INVENTION

It is an object of the present invention to provide an amplifying circuit that can be simplified.

An amplifying circuit according to the present invention has the features of claim 1 and amplifies an input signal input from an input terminal and outputting the signal from an output terminal. The circuit comprises: a first transistor, a second transistor, a third transistor and a fourth transistor provided in an input stage; and a first bias circuit. The input signal is input into a control terminal of the first transistor and a control terminal of the second transistor, a first terminal of the first transistor is connected to a first terminal of the third transistor, a first terminal of the second transistor is connected to a first terminal of the fourth transistor, a second terminal of the first transistor is connected to a first potential, a second terminal of the second transistor is connected to a second potential that is equal to or different from the first potential, a second terminal of the third transistor is connected to a third potential, a second terminal of the fourth transistor is connected to a fourth potential, the first bias circuit is connected between a control terminal of the third transistor and a control terminal of the fourth transistor.

In this case, since the first bias circuit is connected between the control terminal of the third transistor and the control terminal of the fourth transistor, a voltage between the control terminals of the third transistor and the fourth transistor can be fixed by the first bias circuit. Therefore, a plurality of bias circuits does not have to be used as a power standard. That is to say, since only the one first bias circuit may be used, a circuit configuration can be simplified. Since only the one first bias circuit is used, a stability of the voltage between the control terminals can be made to be higher than a case using a plurality of bias circuits.

The first bias circuit is provided between the third transistor and the fourth transistor, so that the first bias circuit can compensate changed temperatures of the first transistor, the second transistor, the third transistor and the fourth transistor. As a result, temperature stability in the amplifying circuit according to the present invention can be improved. When a signal that suddenly changes is input into an input and transient response characteristics of the third transistor and the fourth transistor are not satisfactory, the signal is not transmitted. When a bias circuit is a constant current circuit, drive currents of the third transistor and the fourth transistor are limited by the constant current circuit. However, when the bias circuit is a constant voltage circuit, the drive currents are not limited, and thus the third transistor and the fourth transistor can be driven.

Preferably the amplifying circuit further comprises: a first resistor, a second resistor, a third resistor and a fourth resistor. The first resistor is connected between the first terminal of the first transistor and the first terminal of the third transistor, the second resistor is connected between the first terminal of the second transistor and the first terminal of the fourth transistor, the third resistor is connected to the second terminal of the third transistor, the fourth resistor is connected to the second terminal of the fourth transistor.

In this case, an amplifying amount of the input stage can be determined based on a ratio of the first resistor and the third resistor, and a ratio of the second resistor and the fourth resistor. Linearity of the amplification can be improved by the ratio of the first resistor and the third resistor, and the ratio of the second resistor and the fourth resistor.

Preferably, the amplifying circuit further comprises: a fifth transistor, a sixth transistor, a seventh transistor and an eighth transistor. A control terminal of the fifth transistor is connected to the second terminal of the third transistor, a control terminal of the sixth transistor is connected to a first terminal of the fifth transistor, a control terminal of the seventh transistor is connected to the second terminal of the fourth transistor, a control terminal of the eighth transistor is connected to a first terminal of the seventh transistor, a first terminal of the fifth transistor and a first terminal of the sixth transistor are connected to the third potential, a first terminal of the seventh transistor and a first terminal of the eighth transistor are connected to the fourth potential, a second terminal of the fifth transistor is connected to a fifth potential or a second terminal of the sixth transistor, a second terminal of the seventh transistor is connected to a sixth potential or a second terminal of the eighth transistor, the second terminal of the sixth transistor and the second terminal of the eighth transistor are connected to the output terminal of the amplifying circuit.

In this case, since Darlington connection is made between the fifth transistor and the sixth transistor and between the seventh transistor and the eighth transistor, an amplification factor of the electric current in the circuit can be heightened.

Further, drive of a capacitor load to be connected to an output terminal OUT depends on a current value of the output. For this reason, an output signal can be instantaneously obtained despite a low electric current at stationary time in the sixth transistor, thereby achieving a satisfactory slew rate.

Preferably, the amplifying circuit further comprises: a negative feedback resistor. A negative feedback signal from the output terminal is supplied to the control terminal of the first transistor and the control terminal of the second transistor via the negative feedback resistor.

In this case, the amplifying circuit of the inverting circuit can be formed, and a noise and a distortion can be reduced by a negative feedback resistor. Since the negative feedback resistor also has a function of an output resistor, the circuit can be simplified.

Preferably, the amplifying circuit further comprises: a ninth transistor, a tenth transistor, an eleventh transistor, a twelfth transistor, a second bias circuit and a third bias circuit. A control terminal of the ninth transistor is connected to the second terminal of the third transistor, a first terminal of the ninth transistor is connected to a first terminal of the tenth transistor, a second terminal of the ninth transistor is connected to the third potential, a control terminal of the eleventh transistor is connected to the second terminal of the fourth transistor, a first terminal of the eleventh transistor is connected to a first terminal of the twelfth transistor, a second terminal of the eleventh transistor is connected to the fourth potential, a second terminal of the tenth transistor and a second terminal of the twelfth transistor are connected to the output terminal, the second bias circuit is connected between the third potential and a control terminal of the tenth transistor, the third bias circuit is connected between the fourth potential and a control terminal of the twelfth transistor.

In this case, since the second bias circuit and the third bias circuit are provided in the output stage, a bias current at the output stage can be independently designed. As a result, a degree of freedom in the circuit can be heightened.

Preferably, a negative feedback signal from the output terminal is supplied to a reference point of the first bias circuit.

When the amplifying circuit is a non-inverting circuit, the negative feedback signal is connected to a reference point of the first bias circuit. As a result, the reference point of the first bias circuit in the non-inverting circuit is adjusted so that the standard of the first bias circuit is changed, and the output can be stabilized.

Preferably, the amplifying circuit further comprising: a short-circuit protection circuit, the short-circuit protection circuit includes a thirteenth transistor connected between the control terminal of the third transistor and the control terminal of the fourth transistor, the thirteenth transistor can be switched from an off state to an on state by an external signal so that the control terminal of the third transistor and the control terminal of the fourth transistor are short-circuited.

In this case, the thirteenth transistor can be controlled to be changed from an off state into an on state according to the external signal, so that the control terminals of the third transistor and the fourth transistor are short-circuited. For this reason, the first bias circuit is stopped. For example, the external signal is output at abnormal time (including zero output), so that the amplifying circuit is easily stopped and protected.

### BRIEF DESCRIPTION OF THE DRAWINGS

Fig. 1 is a typical circuit diagram illustrating one example of an amplifying circuit according to one embodiment of the present invention;
Fig. 2 is a typical circuit diagram illustrating one example of a bias circuit according to the present invention;
Fig. 3 is a typical explanatory diagram for describing an operation of the amplifying circuit shown in Fig. 1;
Fig. 4 is a typical explanatory diagram for describing an operation of the amplifying circuit shown in Fig. 1;
Fig. 5 is a typical circuit diagram illustrating an example of an amplifying circuit;
Fig. 6 is a typical circuit diagram illustrating one example of the amplifying circuit according to a second embodiment;
Fig. 7 is a typical circuit diagram where the amplifying circuit is applied to a current-voltage conversion circuit according to the first embodiment;
Fig. 8 is a typical circuit diagram illustrating one example of the amplifying circuit according to a fourth embodiment.

### DETAILED DESCRIPTION OF THE PREFERRED EMBODIMENTS

Embodiments of the present invention will be described below with reference to the drawings.

### (First Embodiment)

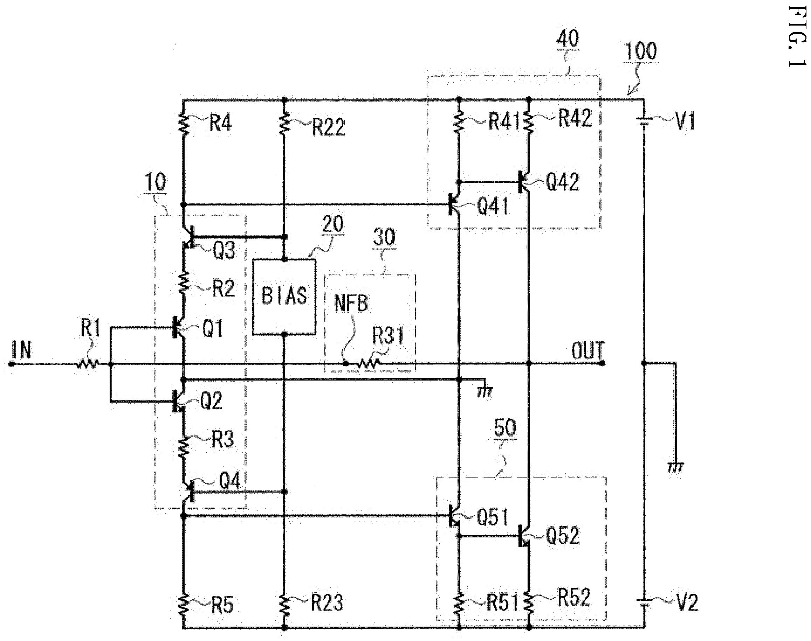

Fig. 1 is a typical circuit diagram illustrating one example of an amplifying circuit according to the first embodiment. An amplifying circuit 100 shown in Fig. 1 is an inverting circuit.

As shown in Fig. 1, the amplifying circuit 100 includes an input terminal IN, an input stage 10, a bias circuit 20, an output resistor section 30, and output stages 40 and 50.

### (Input Stage 10)

The input stage 10 includes a PNP transistor Q1, an NPN transistor Q2, an NPN transistor Q3, a PNP transistor Q4 and emitter resistors R2 and R3.

As shown in Fig. 1, a base of the PNP transistor Q1 and a base of the NPN transistor Q2 are connected to the input terminal IN via an input resistor R1. A collector of the PNP transistor Q1 and a collector of the NPN transistor Q2 are connected and grounded (GND).

An emitter of the NPN transistor Q3 is connected to an emitter of the PNP transistor Q1 via the emitter resistor R2.

An emitter of the PNP transistor Q4 is connected to an emitter of the NPN transistor Q2 via an emitter resistor R3.

A collector of the NPN transistor Q3 is connected to a line of a constant power source V1 via a resistor R4, and a collector of the PNP transistor Q4 is connected to a line of a constant power source V2 via a resistor R5.

### (Bias Circuit 20)

The bias circuit 20 is connected between a base of the NPN transistor Q3 and a base of the PNP transistor Q4. The bias circuit 20 is connected to the line of the constant power source V1 via a resistor R22, and is connected to the line of the constant power source V2 via a resistor R23. An internal configuration of the bias circuit 20 will be described later.

### (Output Resistor Section 30)

As shown in Fig. 1, the output resistor section 30 includes an output resistor (negative feedback resistor) R31. The output resistor section 30 is inserted between base terminals of the PNP transistor Q1 and the NPN transistor Q2 and an output terminal OUT so as to form NFB(negative feedback).

### (Output Stage 40)

The output stage 40 includes a PNP transistor Q41, a PNP transistor Q42, an emitter resistor R41 and an emitter resistor R42.

A base of the PNP transistor Q42 is connected to an emitter of the PNP transistor Q41. Concretely, the PNP transistor Q41 and the PNP transistor Q42 are Darlington-connected. A collector of the PNP transistor Q42 is connected to the output terminal OUT.

A base of the PNP transistor Q41 is connected to a collector of the NPN transistor Q3 at the input stage, and a collector of the PNP transistor Q41 is grounded (GND).

An emitter of the PNP transistor Q41 is connected to the line of the constant power source V1 via the emitter resistor 41, and an emitter of the PNP transistor Q42 is connected to the line of the constant power source V1 via the emitter resistor R42.

### (Output Stage 50)

Similarly, the output stage 50 includes an NPN transistor Q51, an NPN transistor Q52, and emitter resistors R51 and R52.

A base of the NPN transistor Q52 is connected to an emitter of the NPN transistor Q51. Concretely, the NPN transistor Q51 and the NPN transistor Q52 are Darlington-connected. A collector of the NPN transistor Q52 is connected to the output terminal OUT.

A base of the NPN transistor Q51 is connected to a collector of the PNP transistor Q4 at the input stage, and a collector of the NPN transistor Q51 is grounded (GND).

An emitter of the NPN transistor Q51 is connected to the line of the constant power source V2 via the emitter resistor R51, and an emitter of the NPN transistor Q52 is connected to the line of the constant power source V2 via the emitter resistor R52.

### (Details of the Bias Circuit 20)

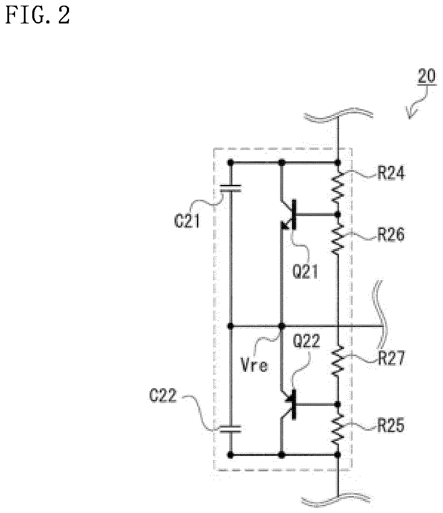

Fig. 2 is a typical circuit diagram for describing details of the bias circuit 20.

As shown in Fig. 2, the bias circuit 20 includes a capacitor C21, a capacitor C22, an NPN biasing transistor Q21, a PNP biasing transistor Q22, a biasing resistor R24, a biasing resistor R25, a biasing resistor R26 and a biasing resistor R27.

An emitter of the NPN transistor Q21 is connected to a reference terminal Vre (ground potential GND). The capacitor C21 is provided between an emitter and a collector of the NPN transistor Q21, and the resistor R24 is provided between the collector and a base.

An emitter of the PNP transistor Q22 is connected to the reference terminal Vre (the ground potential GND). The capacitor C22 is provided between an emitter and a collector of the PNP transistor Q22, and the resistor R25 is provided between the collector and a base.

The resistors R26 and R27 are connected in series between the bases of the NPN transistor Q21 and the PNP transistor Q22.

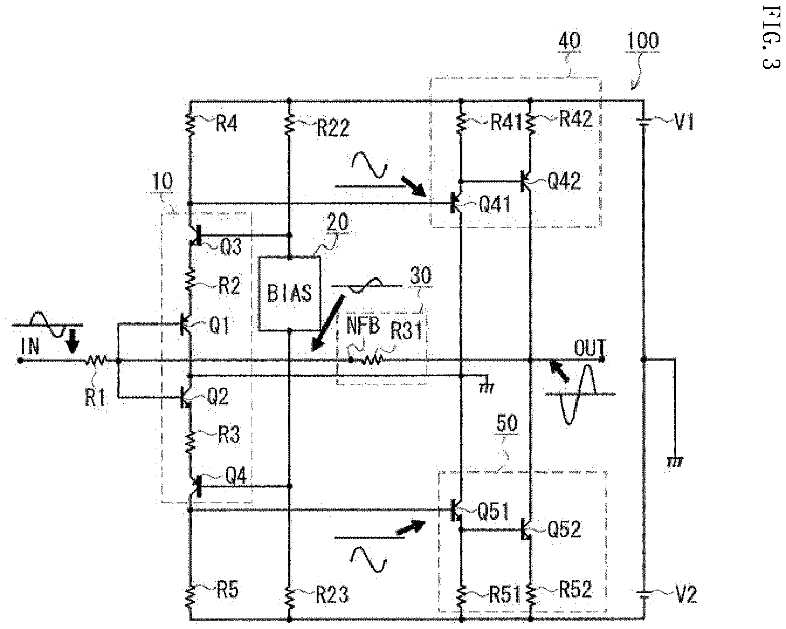

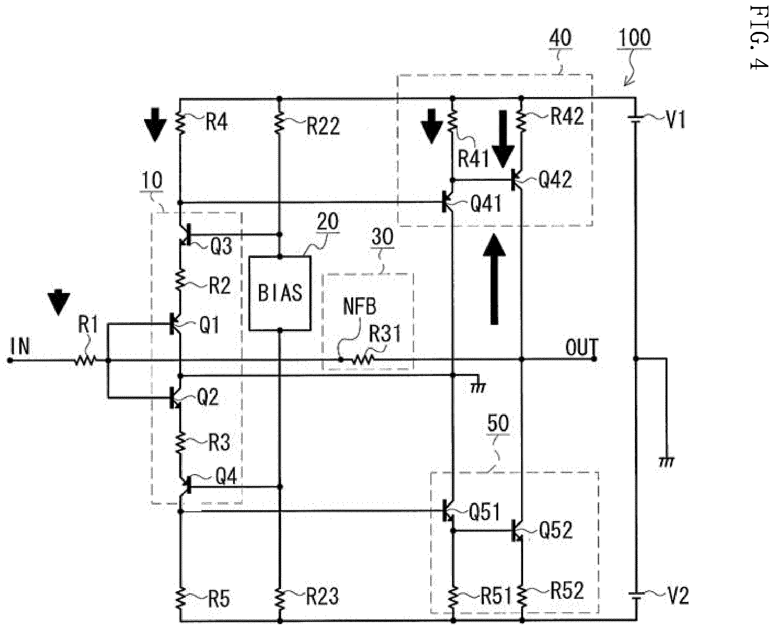

Fig. 3 and Fig. 4 are typical explanatory diagrams for describing an operation of the amplifying circuit 100 shown in Fig. 1 and Fig. 2.

In the amplifying circuit 100 shown in Fig. 3, when a signal is not input into the input terminal IN, any bias current is applied from the bias circuit 20 to the emitter resistor R2. As a result, an electric current flowing in the resistor R4 is determined. Therefore, an electric potential is generated in the resistor R4, and electric currents flowing in the emitter resistor 41 and the emitter resistor R42 are determined.

Similarly, since the amplifying circuit 100 has a symmetrical configuration in an up-down direction, the emitter resistor R3 and the resistor R5 are put into the same state.

On the other hand, when a current signal of a SIN waveform is input into the input terminal IN of the amplifying circuit 100 shown in Fig. 3, the current signal of the SIN waveform that is shifted positively is allowed to flow in the PNP transistor Q41 by amplification of the NPN transistor Q3.

A current signal of an SIN waveform that is negatively shifted is allowed to flow in the NPN transistor Q51 by amplification of the PNP transistor Q4. As a result, the amplified current signal of the SIN waveform flows in the output terminal OUT.

The current signal whose phase is opposite to that of the SIN waveform input into the input terminal IN is negatively fed back via the output resistor (negative feedback resistor) R31 (negative feedback).

As a result, the current signal of the SIN waveform that is stably amplified is output from the PNP transistor Q42 and the NPN transistor Q52 via the output terminal OUT.

Next, when a signal of a rectangular wave is input into the input terminal IN of the amplifying circuit 100 shown in Fig. 4, a voltage width of the emitter resistor R2 is increased, and an electric current flowing in the emitter resistor R2 increases according to the input rectangular wave.

The electric current flowing in the emitter resistor R2 is added to the resistor R4, and a voltage width of the resistor R4 is increased. A voltage to be applied to the emitter resistor R42 has a value obtained by subtracting a voltage (Vbe) between the base and the emitter of the PNP transistor Q41 and the PNP transistor Q42 from the voltage to be applied to the resistor R4.

It is assumed that an electric current of 1 mA flows in the resistor R4 and an electric current of 10 mA flows in the emitter resistor R42. When the voltage width of the resistor R4 is 1.5 V under this condition, a voltage width of the emitter resistor R42 becomes 0.3 V according to 1.5 V - (Vbe(Q42) + Vbe(Q41)). Further, under this condition, the resistor R4 is 1.5 KΩ, and the resistor R42 is 30 Ω.

When the input signal in the above state is increased by 10 mA, the voltage width of the resistor R4 is 15 V, and the voltage width of the emitter resistor R42 changes to 13.8 V. As a result, the voltage width of the resistor R42 changes from 0.3 V to 13.8 V, and an output current of 460 mA can be obtained from the input signal of the input current of 10 mA.

Particularly, the rectangular wave has instant leading edge and trailing edge. Further, drive of a capacitor load to be connected to the output terminal OUT depends on a current value of the output. For this reason, despite that the electric current in the PNP transistor Q42 at the stationary time is low (in the above case of 10 mA), an output signal (460 mA) can be obtained instantaneously, thereby achieving a satisfactory slew rate.

In the amplifying circuit 100, the bias circuit 20 is put into a floating state at lines of constant power sources V1 and V2, so that the voltage between the bases of the NPN transistor Q3 and the PNP transistor Q4 can be fixed by the bias circuit 20. Further, the bias circuit 20 eliminates necessity that a lot of constant current circuits are provided, thereby simplifying the circuit. Further, an influence of ripple from the lines of the constant power sources V1 and V2 can be reduced.

As described above, in the amplifying circuit 100 according to this embodiment, since the electric current at the stationary time can be repressed, unnecessary heat generation can be repressed. As a result, temperature stability of the amplifying circuit 100 can be improved. Further, the NPN transistor Q21 and the PNP transistor Q22 are thermally bonded to the transistors Q1 to Q4, so that an influence of a characteristic change due to the heats of the respective transistors can be cancelled, thereby stabilizing the output voltage. When the respective transistors of the output stages 40 and 50 are thermally bonded to the NPN transistor Q21 and the PNP transistor Q22, the output voltage can be further stabilized.

Since a base feedback system where NFB (negative feedback) is connected to the input signal is adopted, a physical shift does not occur at a difference synthesizing point, and thus accurate negative feedback can be realized.

Drive currents of the transistors Q3 and Q4 are supplied from the bias circuit 20 (particularly, the capacitors C21 and C22) without depending on the constant power sources V1 and V2. As a result, the drive currents can be instantaneously supplied to the transistors Q3 and Q4. If the drive currents are supplied from the constant power sources V1 and V2 to the transistors Q3 and Q4, high electric current should always flow in the resistors R22 and R23. For this reason, power consumption increases, but this example can solve such a problem.

In the amplifying circuit 100, the input resistor R1 can be provided with both functions of an amplifier gain and an input filter. The output resistor (negative feedback resistor) R31 can reduce noise and distortion, and can be provided with both functions of an amplifier gain and an output resistor. As a result, the circuit configuration can be simplified.

At the output stages 40 and 50, the emitter resistor R42, the emitter resistor R52 and the output resistor (negative feedback resistor) R31 can easily adjust the amplifier gain.

In the amplifying circuit 100 shown in Fig. 1, the number of stages is small and the number of poles can be repressed. For this reason, a defect of frequency characteristics and oscillation can be prevented.

In the input stage 10, a gain of the NPN transistor Q3 can be adjusted by the emitter resistor R2 and the resistor R4. Further, a gain of the PNP transistor Q4 can be adjusted by the emitter resistor R3 and the resistor R5.

In the amplifying circuit 100 according to the first embodiment, the NPN transistor Q3 and the PNP transistor Q4 can be regarded as base grounds. As a result, a wide band of the amplifying circuit 100 can be realized.

In a conventional current feedback circuit, a stage having a plurality of constant current sources is provided, and it is difficult to adjust a bias current and a DC offset. However, in the amplifying circuit 100 according to the first embodiment, the resistors R24 and R25, and the resistors R26 and R27 are adjusted so that the DC offset can be adjusted by the resistors R24 and R25, and the bias current can be adjusted by the resistors R26 and R27.

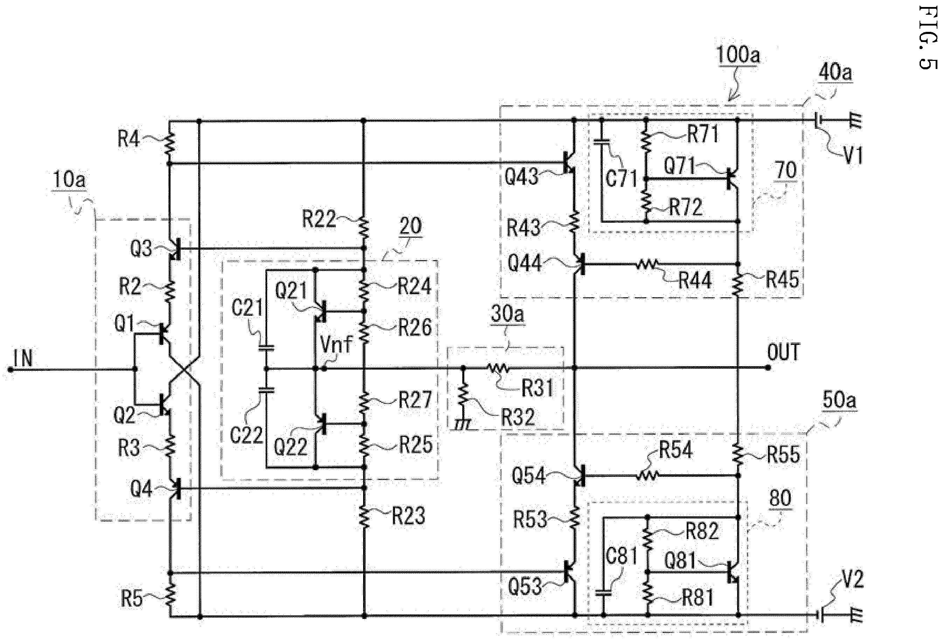

The first embodiment is not limited to the above circuit configuration. For example, a collector of the transistor Q1 and a collector of the transistor Q2 may be connected to different potentials. That is to say, the collector of the transistor Q1 may be connected to the constant power source V2, and the collector of the transistor Q2 may be connected to the constant power source V1. In another manner, the collector of the transistor Q1 may be connected between the bias circuit 20 and the resistor R22, and the collector of the transistor Q2 may be connected between the bias circuit 20 and the resistor R23. Further, the collector of the transistor Q41 and the collector of the transistor Q42 may be connected to different potentials. In another manner, the collector of the transistor Q41 may be connected to the collector of the transistor Q42, and the collector of the transistor Q51 may be connected to the collector of the transistor Q52. An amplifying circuit 100a shown in Fig. 5 is one example of a non-inverting circuit. As shown in Fig. 5, the amplifying circuit 100a has an input stage 10a instead of the input stage 10 of the amplifying circuit 100. An output resistor section 30a is provided instead of the output resistor section 30. Further, an output stage 40a is provided instead of the output stage 40, and an output stage 50a is provided instead of the output stage 50.

A circuit equivalent to the bias circuit in Fig. 2 is used as the bias circuit 20, and it is an adjusting stage of a bias current and an output DC voltage and produces the equivalent effect. The reference terminal of the bias circuit 20 is connected to a path of the negative feedback, and functions as a voltage feedback terminal Vnf.

### (Input Stage 10a)

The input stage 10a includes the PNP transistor Q1, the NPN transistor Q2, the NPN transistor Q3, the PNP transistor Q4 and the emitter resistors R2 and R3.

As shown in Fig. 5, the base of the PNP transistor Q1 and the base of the NPN transistor Q2 are connected to the input terminal IN.

The collector of the PNP transistor Q1 is connected to the line of the constant power source V2. The collector of the NPN transistor Q2 is connected to the line of the constant power source V1. The emitter of the NPN transistor Q3 is connected to the emitter of the PNP transistor Q1 via the emitter resistor R2. The emitter of the PNP transistor Q4 is connected to the emitter of the NPN transistor Q2 via the emitter resistor R3.

The bias circuit 20 is provided between the base of the NPN transistor Q3 and the base of the PNP transistor Q4, and the collector of the NPN transistor Q3 is connected to the line of the constant power source V1 via the resistor R4. The collector of the PNP transistor Q4 is connected to the line of the constant power source V2 via the resistor R5.

### (Output Resistor Section 30a)

As shown in Fig. 5, an output resistor section 30a includes the output resistor (negative feedback resistor) R31 and a resistor R32. The resistor R32 is provided to a side closer to the input stage 10a than the resistor R31, and its one end is grounded (GND).

### (Output Stage 40a)

The output stage 40a includes an NPN transistor Q43, a PNP transistor Q44, an emitter resistor R43, a resistor R44, a resistor R45, and a bias circuit 70.

An emitter of the NPN transistor Q43 is connected to an emitter of the PNP transistor Q44 via the emitter resistor R43. Concretely, the NPN transistor Q43 and the PNP transistor Q44 are Darlington-connected. A collector of the PNP transistor Q44 is connected to the output terminal OUT.

Abase of the NPN transistor Q43 is connected to the collector of the NPN transistor Q3 at the input stage, and a collector of the NPN transistor Q43 is connected to the line of the constant power source V1.

A base of the PNP transistor Q44 is connected to a collector of a PNP transistor Q71, described later, via the resistor R44. As a result, the resistor 44 as well as a capacity between the collector and the base of the PNP transistor Q44 forms a low-pass filter. Further, the resistor R45 is inserted between the collector of the PNP transistor Q71 and a collector of a transistor Q81 of a bias circuit 80, described later, in series with respect to a resistor R55, described later.

### (Bias Circuit 70)

As shown in Fig. 5, the bias circuit 70 includes a capacitor C71, the PNP transistor Q71, and resistors R71 and R72.

An emitter of the PNP transistor Q71 is connected to the line of the constant power source V1. A base of the PNP transistor Q71 is connected to the line of the constant power source V1 via the resistor R71. Further, a resistor R72 is inserted between the base and the collector of the PNP transistor Q71.

The capacitor C71 is inserted between the collector of the PNP transistor Q71 and the line of the constant power source V1.

### (Output Stage 50a)

The output stage 50a includes a PNP transistor Q53, an NPN transistor Q54, emitter resistors R53, R54 and R55, and the bias circuit 80.

An emitter of the PNP transistor Q53 is connected to an emitter of the NPN transistor Q54 via the emitter resistor R53. Concretely, the PNP transistor Q53 and the NPN transistor Q54 are Darlington-connected. A collector of the NPN transistor Q54 is connected to the output terminal OUT.

A base of the PNP transistor Q53 is connected to the collector of the PNP transistor Q4 at the input stage, and a collector of the PNP transistor Q53 is connected to the line of the constant power source V2.

A base of the NPN transistor Q54 is connected to the collector of the NPN transistor Q81, described later, via the emitter resistor R54. As a result, the resistor R54 as well as a capacity between the collector and the base of the NPN transistor Q54 form a low-pass filter.

### (Bias Circuit 80)

As shown in Fig. 5, the bias circuit 80 includes a capacitor C81, the NPN transistor Q81, and resistors R81 and R82.

An emitter of the NPN transistor Q81 is connected to the line of the constant power source V2. Abase of the NPN transistor Q81 is connected to the line of the constant power source V2 via the resistor R81. Further, the resistor R82 is inserted between the base and the collector of the NPN transistor Q81.

The capacitor C81 is inserted between the collector of the NPN transistor Q81 and the line of the constant power source V2.

The amplifying circuit 100a is one example of the non-inverting circuit composed of a symmetrical circuit. In the amplifying circuit 100a, the later stage amplifying is performed by the PNP transistor Q44, the NPN transistor Q54, the emitter resistor R43, the emitter resistor R53, and the output resistor (negative feedback resistor) R31.

A bias current can be adjusted by using the bias circuit 20 at the input stage 10a, and independently from this adjustment, the bias current can be adjusted by using the output stages 40a and 50a. As a result, a degree of circuit design freedom can be widened. Further, the output resistors (negative feedback resistors) R31 and R32 can determine a total gain of the amplifying circuit 100a.

In the amplifying circuit 100a, the transistors Q1 and Q3 and the resistor R2 of the input stage 10a have the same circuit configuration as that of the transistors Q43 and Q44 and the resistor R43 at the output stage 40a. The transistors Q2 and Q4 and the resistor R3 of the input stage 10a have the same circuit configuration as that of the transistors Q53 and Q54 and the resistor R53 at the output stage 50a.

Therefore, the output signal and the input signal establish a non-inverting relationship. The non-inverted output signal is supplied to the bases of the transistors Q3 and Q4 (via the bias circuit 20), so that the negative feedback can be realized.

More specifically, a negative feedback path is connected to the voltage feedback terminal Vnf (the reference terminal) of the bias circuit 20. Therefore, as a negative feedback path, a negative feedback path to the transistor Q3 and a negative feedback path to the transistor Q4 do not have to be separately provided. That is to say, since a supply path of the drive currents from the bias circuit 20 to the transistors Q3 and Q4 can be used also as the negative feedback path to the transistors Q3 and Q4, the circuit configuration can be simplified.

### (Second Embodiment)

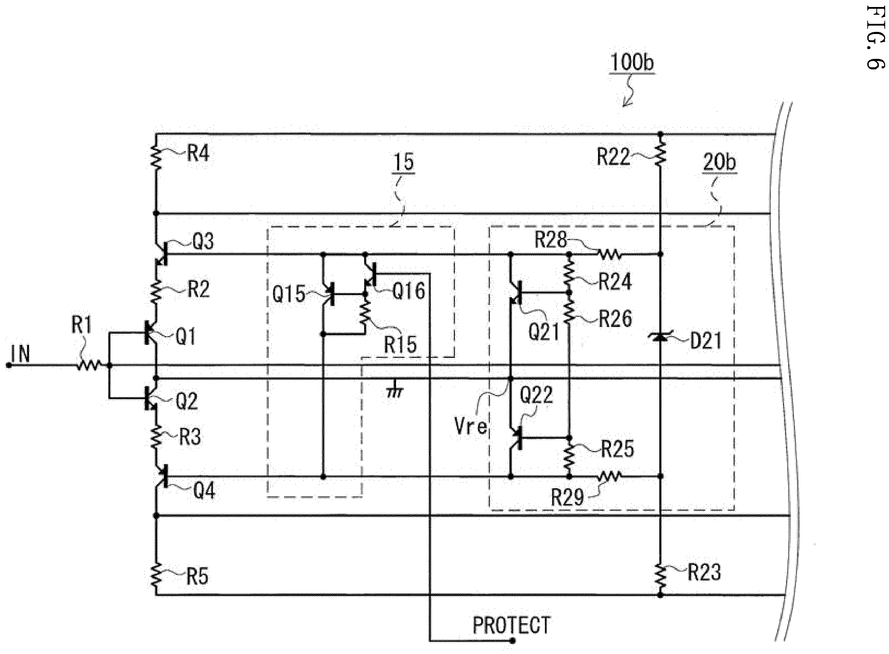

Fig. 6 is a typical circuit diagram illustrating one example of the amplifying circuit according to a second embodiment. A different point between the amplifying circuit 100b according to the second embodiment and the amplifying circuit 100 according to the first embodiment will be described below.

As shown in Fig. 6, the amplifying circuit 100b further has a short-circuit protection circuit 15 additionally to the amplifying circuit 100, and a bias circuit 20b instead of the bias circuit 20.

### (Short-Circuit Protection Circuit 15)

As shown in Fig. 6, the short-circuit protection circuit 15 includes a PNP transistor Q15, an NPN transistor Q16, a resistor R15, and a short-circuit protection input terminal PROTECT.

An emitter of the PNP transistor Q15 is connected between the base of the NPN transistor Q3 and the bias circuit 20b. A collector of the PNP transistor Q15 is connected between the base of the PNP transistor Q4 and the bias circuit 20b. Abase of the PNP transistor Q15 is connected to an emitter of NPN transistor Q16.

A collector of the NPN transistor Q16 is connected between the base of the NPN transistor Q3 and the bias circuit 20b. An emitter of the NPN transistor Q16 is connected to the collector of the PNP transistor Q15 via the resistor R15. A base of the NPN transistor Q16 is connected to the short-circuit protection input terminal PROTECT.

### (Bias Circuit 20b)

As shown in Fig. 6, the bias circuit 20b includes the NPN transistor Q21, the PNP transistor Q22, the resistor R24, the resistor R25, the resistor R26, a resistor 28, a resistor 29 and a zener diode D21.

The reference terminal Vre is provided between an emitter of the NPN transistor Q21 and an emitter of the PNP transistor Q22. An emitter of the NPN transistor Q21 is connected to the reference terminal Vre. The resistor R24 is provided between a collector and a base of the NPN transistor Q21.

An emitter of the PNP transistor Q22 is connected to the reference terminal Vre. The resistor R25 is provided between a collector and a base of the PNP transistor Q22.

The resistor R26 is provided between the NPN transistor Q21 and the PNP transistor Q22.

A cathode of the zener diode D21 is connected to the collector of the NPN transistor Q21 via a resistor R28, and an anode of the zener diode D21 is connected to the collector of the PNP transistor Q22 via a resistor R29.

As described above, in the amplifying circuit 100b according to the second embodiment, the
voltage can be made to be constant by the zener diode D21. When the zener diode D21 is used, an influence of a great fluctuation in a supply voltage is not exerted. Further, the short-circuit protection circuit 15 can protect the circuit at abnormality detecting time.

The short-circuit protection circuit 15 will be described below. Any voltage is applied to the short-circuit protection input terminal PROTECT at the normal time. In this case, the NPN transistor Q16 is in an ON state, and the PNP transistor Q15 is in an OFF state.

On the other hand, the short-circuit protection input terminal PROTECT is grounded (GND) at the abnormal time. In this case, the NPN transistor Q16 is in the OFF state and the PNP transistor Q15 is in the ON state, and the base of the NPN transistor Q3 and the base of the PNP transistor Q4 are short-circuited. As a result, the amplification of the amplifying circuit 100b is instantaneously stopped. The amplifying circuit in Fig. 5 can be provided with the short-circuit protection circuit 15.

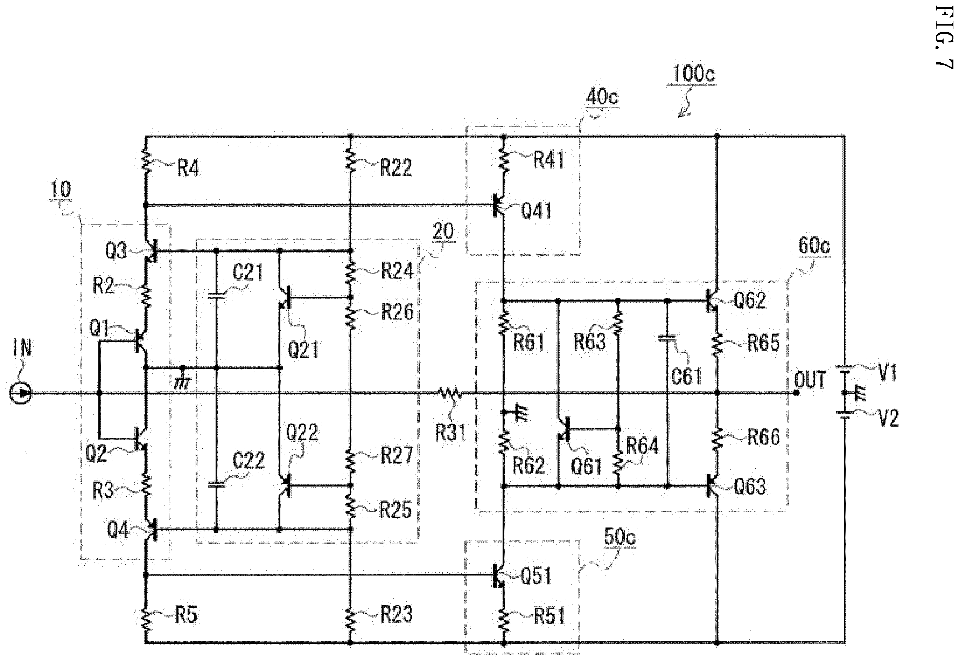

Fig. 7 is a typical circuit diagram where the amplifying circuit according to the first embodiment is applied to a current-voltage conversion circuit. In Fig. 7, an inverting amplification circuit is laid out on the current-voltage conversion circuit.

As shown in Fig. 7, the amplifying circuit 100 is altered into a current-voltage conversion circuit 100c. The current-voltage conversion circuit 100c shown in Fig. 7 includes an output stage 40c, an output stage 50c, and an output stage 60c.

In the output stages 40c and 50c, the Darlington connection is eliminated from the output stages 40 and 50, and the output stage 60c is a circuit for reducing an output impedance.

### (Third Embodiment)

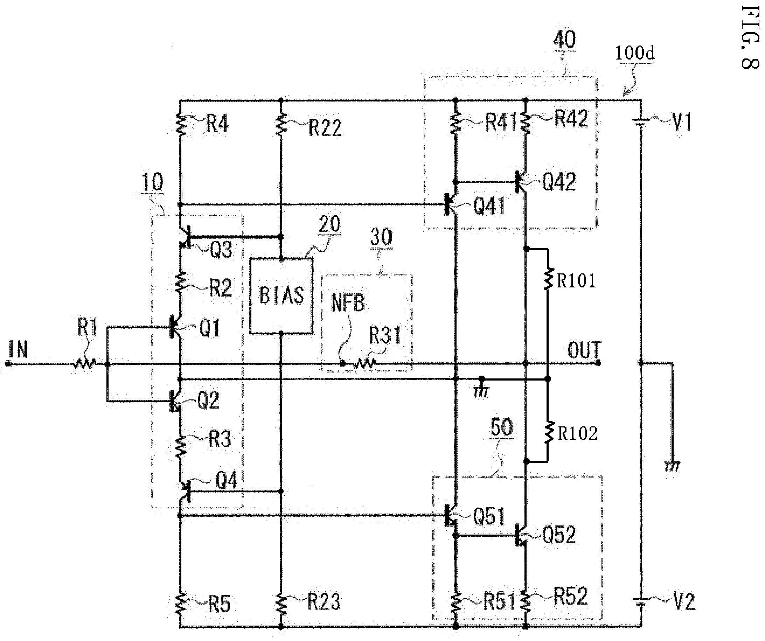

Fig. 8 is a typical circuit diagram illustrating one example of the amplifying circuit according to a fourth embodiment. A different point between the amplifying circuit 100d according to the fourth embodiment and the amplifying circuit 100 according to the first embodiment will be described below.

As shown in Fig. 8, the amplifying circuit 100d further includes resistors R101 and R102. One end of the resistor R101 is connected to the collector of the transistor Q42, and the other end is grounded. One end of the resistor R102 is connected to the collector of the transistor Q52, and the other end is grounded. The collectors of the transistors Q42 and Q52 are grounded via the resistors R101 and R102, thereby preventing gains of the output stages 40 and 50 from fluctuating due to the resistor R31 of the output resistor section 30. The resistor R101 will be described as an example, but the same is true for the resistor R102.

The resistor R42 is an emitter resistor of the transistor Q42. A collector resistor of the transistor Q42 is represented by a resistor obtained by synthesizing the resistor R101, a collector internal resistor of the transistor Q42 and the resistor R31. When an output admittance of the transistor Q42 is represented by hoe, the collector internal resistor is expressed by (1/hoe). When a resistance value of the resistor R101 is very smaller than the collector internal resistor of the transistor Q42 and the resistor R31, contribution of the resistor R101 is dominant in the collector resistor and contribution of the resistor R31 reduces.

When the resistor R101 is not connected, the resistor R31 is lower than the collector internal resistor and the resistor R31 is dominant in the collector resistor of the transistor Q42. That is to say, the gain of the amplifying circuit fluctuates due to the resistance value of the resistor R31. However, when the resistor R101 is provided, an influence of the resistor R31 to be exerted on the gain of the amplifying circuit can be repressed.

In the above embodiments a compensating circuit is not provided, but not limited to this, and any circuit such as a phase compensating circuit may be provided to the output resistor (negative feedback resistor) R31.

## Claims

1. An amplifying circuit (100) for amplifying an input signal input from an input terminal (IN) and outputting the signal from an output terminal (OUT), the circuit (100) comprising:
a first PNP transistor (Q1), a second NPN transistor (Q2), a third NPN transistor (Q3) and a fourth PNP transistor (Q4) provided in an input stage (10); and
a first bias circuit (20), wherein
the input signal (IN) is input into a base terminal of the first PNP transistor (Q1) and a base terminal of the second NPN transistor (Q2),
an emitter terminal of the first PNP transistor (Q1) is connected to an emitter terminal of the third NPN transistor (Q3),
an emitter terminal of the second NPN transistor (Q2) is connected to an emitter terminal of the fourth PNP transistor (Q4),
a collector terminal of the first PNP transistor (Q1) and a collector terminal of the second NPN transistor (Q2) are connected and grounded to ground potential (GND),
a collector terminal of the third NPN transistor (Q3) is connected to a potential of a first constant power source (V1),
a collector terminal of the fourth PNP transistor (Q4) is connected to a potential of a second constant power source (V2),
the first bias circuit (20) is connected between a base terminal of the third NPN transistor (Q3) and a base terminal of the fourth PNP transistor (Q4),
the first bias circuit (20) includes an NPN biasing transistor (Q21), a PNP biasing transistor (Q22), **characterised in that** the first bias circuit (20) further includes a first biasing resistor (R24), a second biasing resistor (R25), a third biasing resistor (R26) and a fourth biasing resistor (R27),
wherein an emitter of the NPN biasing transistor (Q21) is connected to a reference terminal (Vre) corresponding to the ground potential (GND),
wherein the first resistor (R24) is provided between the collector and a base of the NPN biasing transistor (Q21), wherein an emitter of the PNP biasing transistor (Q22) is connected to the reference terminal (Vre),
wherein the second resistor (R25) is provided between the collector and a base of the PNP biasing transistor (Q22),
wherein the third and fourth resistors (R26, R27) are connected in series between the bases of the NPN biasing transistor (Q21) and the PNP biasing transistor (Q22), and
wherein the NPN biasing transistor (Q21) and the PNP biasing transistor (Q22) are thermally bonded to the first PNP transistor (Q1), the second NPN transistor (Q2), the third NPN transistor (Q3) and the fourth PNP transistor (Q4) for compensating temperature changes of the first PNP transistor (Q1), the second NPN transistor (Q2), the third NPN transistor (Q3) and the fourth PNP transistor
(Q4).

2. The amplifying circuit according to claim 1, further comprising:
a first resistor (R2), a second resistor (R3), a third resistor (R4) and a fourth resistor (R5),
wherein
the first resistor (R2) is connected between the emitter terminal of the first PNP transistor (Q1) and the emitter terminal of the third NPN transistor (Q3),
the second resistor (R3) is connected between the emitter terminal of the second NPN transistor (Q2) and the emitter terminal of the fourth PNP transistor (Q4),
the third resistor (R4) is connected to the collector terminal of the third NPN transistor (Q3),
the fourth resistor (R5) is connected to the collector terminal of the fourth PNP transistor (Q4).

3. The amplifying circuit according to claim 1 or 2, further comprising:
a fifth PNP transistor (Q41), a sixth PNP transistor (Q42), a seventh NPN transistor (Q51) and an eighth NPN transistor (Q52), wherein
a base terminal of the fifth PNP transistor (Q41) is connected to the collector terminal of the third NPN transistor (Q3),
a base terminal of the sixth PNP transistor (Q42) is connected to an emitter terminal of the fifth PNP transistor (Q41),
a base terminal of the seventh NPN transistor (Q51) is connected to the collector terminal of the fourth PNP transistor (Q4),
a base terminal of the eighth NPN transistor (Q52) is connected to an emitter terminal of the seventh NPN transistor (Q51),
an emitter terminal of the fifth PNP transistor (Q41) and an emitter terminal of the sixth PNP transistor (Q42) are connected to the potential of the first constant power source (V1),
an emitter terminal of the seventh NPN transistor (Q51) and an emitter terminal of the eighth NPN transistor (Q52) are connected to the potential of the second constant power source (V2),
a collector terminal of the fifth PNP transistor (Q41) is connected to ground potential (GND)),
a collector terminal of the seventh NPN transistor (Q51) is connected to ground potential (GND),
the collector terminal of the sixth PNP transistor (Q41) and the collector terminal of the eighth NPN transistor (Q52) are connected to the output terminal (OUT) of the amplifying circuit (100).

4. The amplifying circuit according to any one of claims 1 to 3, further comprising:
a negative feedback resistor (R31), arranged to supply a negative feedback signal from the output terminal (OUT) to the base terminal of the first PNP transistor (Q1) and the base terminal of the second NPN transistor (Q2) via the negative feedback resistor (R31).

5. The amplifying circuit according to claim 4, further comprising:
a short-circuit protection circuit (15),
the short-circuit protection circuit (15) includes a PNP transistor (Q15)
connected between the base terminal of the third NPN transistor (Q3) and the base terminal of the fourth PNP transistor (Q4),
the PNP transistor (Q15) can be switched from an off state to an on state by an external signal (PROTECT) so that the base terminal of the third NPN transistor (Q3) and the base terminal of the fourth PNP transistor (Q4) are short-circuited.

## Patentansprüche

1. Verstärkungsschaltung (100) zum Verstärken eines von einem Eingangsanschluss (IN) eingegebenen Eingangssignals und zum Ausgeben des Signals aus einem Ausgangsanschluss (OUT), wobei die Schaltung (100) aufweist:
einen ersten PNP-Transistor (Q1), einen zweiten NPN-Transistor (Q2), einen dritten NPN-Transistor (Q3) und einen vierten PNP-Transistor (Q4), welche in einer Eingangsstufe (10) angeordnet sind; und
eine erste Bias-Schaltung (20), wobei
das Eingangssignal (IN) an einen Basisanschluss des ersten PNP-Transistors (Q1) und einen Basisanschluss des zweiten NPN-Transistors (Q2) geführt ist,
ein Emitteranschluss des ersten PNP-Transistors (Q1) mit einem Emitteranschluss des dritten NPN-Transistors (Q3) verbunden ist,
ein Emitteranschluss des zweiten NPN-Transistors (Q2) mit einem Emitteranschluss des vierten PNP-Transistors (Q4) verbunden ist,
ein Kollektoranschluss des ersten PNP-Transistors (Q1) und ein Kollektoranschluss des zweiten NPN-Transistors (Q2) verbunden sind und mit einem Massepotenzial (GND) geerdet sind,
ein Kollektoranschluss des dritten NPN-Transistors (Q3) mit einem Potenzial einer ersten konstanten Stromquelle (V1) verbunden ist,
ein Kollektoranschluss des vierten PNP-Transistors (Q4) mit einem Potenzial einer zweiten konstanten Stromquelle (V2) verbunden ist,
die erste Bias-Schaltung (20) zwischen einem Basisanschluss des dritten NPN-Transistors (Q3) und einem Basisanschluss des vierten PNP-Transistors (Q4) verbunden ist,
die erste Bias-Schaltung (20) einen NPN-Biastransistor (Q21), einen PNP-Biastransistor (Q22) aufweist,
**dadurch gekennzeichnet, dass** die erste Bias-Schaltung (20) ferner einen ersten Biaswiderstand (R24), einen zweiten Biaswiderstand (R25), einen dritten Biaswiderstand (R26) und einen vierten Biaswiderstand (R27) aufweist,
wobei ein Emitter des NPN-Biastransistors (Q21) mit einem dem Massepotenzial (GND) entsprechenden Referenzanschluss (Vre) verbunden ist,
wobei der erste Widerstand (R24) zwischen dem Kollektor und einer Basis des NPN-Biastransistors (Q21) angeordnet ist,
wobei ein Emitter des PNP-Biastransistors (Q22) an den Referenzanschluss (Vre) verbunden ist,
wobei der zweite Widerstand (R25) zwischen dem Kollektor und einer Basis des PNP-Biastransistors (Q22) angeordnet ist,
wobei der dritte und der vierte Widerstand (R26, R27) zwischen der Basis des NPN-Biastransistors (Q21) und der Basis des PNP-Biastransistors (Q22) in Reihe geschaltet sind, und
wobei der NPN-Biastransistor (Q21) und der PNP-Biastransistor (Q22) mit dem ersten PNP-Transistor (Q1), dem zweiten NPN-Transistor (Q2), dem dritten NPN-Transistor (Q3) und dem vierten PNP-Transistor (Q4) thermisch verbunden sind, um Temperaturänderungen des ersten PNP-Transistors (Q1), des zweiten NPN-Transistors (Q2), des dritten NPN-Transistors (Q3) und des vierten PNP-Transistors (Q4) auszugleichen.

2. Verstärkungsschaltung nach Anspruch 1, ferner aufweisend:
einen ersten Widerstand (R2), einen zweiten Widerstand (R3), einen dritten Widerstand (R4) und einen vierten Widerstand (R5), wobei
der erste Widerstand (R2) zwischen dem Emitteranschluss des ersten PNP-Transistors (Q1) und dem Emitteranschluss des dritten NPN-Transistors (Q3) verbunden ist,
der zweite Widerstand (R3) zwischen dem Emitteranschluss des zweiten NPN-Transistors (Q2) und dem Emitteranschluss des vierten PNP-Transistors (Q4) verbunden ist,
der dritte Widerstand (R4) mit dem Kollektoranschluss des dritten NPN-Transistors (Q3) verbunden ist,
der vierte Widerstand (R5) mit dem Kollektoranschluss des vierten PNP-Transistors (Q4) verbunden ist.

3. Verstärkungsschaltung nach Anspruch 1 oder 2, ferner aufweisend:
einen fünften PNP-Transistor (Q41), einen sechsten PNP-Transistor (Q42), einen siebten NPN-Transistor (Q51) und einen achten NPN-Transistor (Q52), wobei
ein Basisanschluss des fünften PNP-Transistors (Q41) mit dem Kollektoranschluss des dritten NPN-Transistors (Q3) verbunden ist,
ein Basisanschluss des sechsten PNP-Transistors (Q42) mit einem Emitteranschluss des fünften PNP-Transistors (Q41) verbunden ist,
ein Basisanschluss des siebten NPN-Transistors (Q51) mit dem Kollektoranschluss des vierten PNP-Transistors (Q4) verbunden ist,
ein Basisanschluss des achten NPN-Transistors (Q52) mit einem Emitteranschluss des siebten NPN-Transistors (Q51) verbunden ist,
ein Emitteranschluss des fünften PNP-Transistors (Q41) und ein Emitteranschluss des sechsten PNP-Transistors (Q42) mit dem Potenzial der ersten konstanten Stromquelle (V1) verbunden sind,
ein Emitteranschluss des siebten NPN-Transistors (Q51) und ein Emitteranschluss des achten NPN-Transistors (Q52) mit dem Potenzial der zweiten konstanten Stromquelle (V2) verbunden sind,
ein Kollektoranschluss des fünften PNP-Transistors (Q41) mit Massepotenzial (GND) verbunden ist,
ein Kollektoranschluss des siebten NPN-Transistors (Q51) mit Massepotenzial (GND) verbunden ist,
der Kollektoranschluss des sechsten PNP-Transistors (Q41) und der Kollektoranschluss des achten NPN-Transistors (Q52) mit dem Ausgangsanschluss (OUT) der Verstärkungsschaltung (100) verbunden sind.

4. Verstärkungsschaltung nach einem der Ansprüche 1 bis 3, ferner aufweisend:
einen Gegenkopplungs-Widerstand (R31), welcher so angeordnet ist, dass ein negatives Rückkopplungssignal von dem Ausgangsanschluss (OUT) an den Basisanschluss des ersten PNP-Transistors (Q1) und an den Basisanschluss des zweiten NPN-Transistors (Q2) über den Gegenkopplungs-Widerstand (R31) geführt ist.

5. Die Verstärkungsschaltung nach Anspruch 4, ferner aufweisend:
eine Kurzschlussschutz-Schaltung (15),
wobei die Kurzschlussschutz-Schaltung (15) einen zwischen dem Basisanschluss des dritten NPN-Transistors (Q3) und dem Basisanschluss des vierten PNP-Transistors (Q4) verbundenen PNP-Transistor (Q15) aufweist,
wobei der PNP-Transistor (Q15) derart durch ein externes Signal (PROTECT) von einem Sperrzustand in einen Durchlasszustand schaltbar ist, dass der Basisanschluss des dritten NPN-Transistors (Q3) und der Basisanschluss des vierten PNP-Transistors (Q4) miteinander kurzgeschlossen sind.

## Revendications

1. Circuit amplificateur (100) destiné à amplifier un signal d'entrée appliqué à partir d'une borne d'entrée (IN) et à délivrer le signal à partir d'une borne de sortie (OUT), le circuit (100) comprenant :
un premier transistor PNP (Q1), un deuxième transistor NPN (Q2), un troisième transistor NPN (Q3) et un quatrième transistor PNP (Q4) placés dans un étage d'entrée (10) ; et
un premier circuit de polarisation (20), dans lequel :
le signal d'entrée (IN) est appliqué à une borne de base du premier transistor PNP (Q1) et à une borne de base du deuxième transistor NPN (Q2),
une borne d'émetteur du premier transistor PNP (Q1) est connectée à une borne d'émetteur du troisième transistor NPN (Q3),
une borne d'émetteur du deuxième transistor NPN (Q2) est connectée à une borne d'émetteur du quatrième transistor PNP (Q4),
une borne de collecteur du premier transistor PNP (Q1) et une borne de collecteur du deuxième transistor NPN (Q2) sont connectées et mises à la terre et au potentiel de terre (GND),
une borne de collecteur du troisième transistor NPN (Q3) est connectée à un potentiel de première source de courant constant (V1),
une borne de collecteur du quatrième transistor PNP (Q4) est connectée à un potentiel de seconde source de courant constant (V2),
le premier circuit de polarisation (20) est connecté entre une borne de base du troisième transistor NPN (Q3) et une borne de base du quatrième transistor PNP (Q4),
le premier circuit de polarisation (20) comporte un transistor de polarisation NPN (Q21), un transistor de polarisation PNP (Q22), **caractérisé en ce que** le premier circuit de polarisation (20) comporte en outre une première résistance de polarisation (R24), une deuxième résistance de polarisation (R25), une troisième résistance de polarisation (R26) et une quatrième résistance de polarisation (R27),
dans lequel un émetteur du transistor de polarisation NPN (Q21) est connecté à une borne de référence (Vre) correspondant au potentiel de terre (GND),
dans lequel la première résistance (R24) est placée entre le collecteur et une base du transistor de polarisation NPN (Q21),
dans lequel un émetteur du transistor de polarisation PNP (Q22) est connecté à la borne de référence (Vre),
dans lequel la deuxième résistance (R25) est placée entre le collecteur et une base du transistor de polarisation PNP (Q22),
dans lequel les troisième et quatrième résistances (R26, R27) sont connectées en série entre les bases du transistor de polarisation NPN (Q21) et du transistor de polarisation PNP (Q22), et
dans lequel le transistor de polarisation NPN (Q21) et le transistor de polarisation PNP (Q22) sont thermiquement liés au premier transistor PNP (Q1), au deuxième transistor NPN (Q2), au troisième transistor NPN (Q3) et au quatrième transistor PNP (Q4) pour compenser des variations de température du premier transistor PNP (Q1), du deuxième transistor NPN (Q2), du troisième transistor NPN (Q3) et du quatrième transistor PNP (Q4).

2. Circuit amplificateur selon la revendication 1, comprenant en outre :
une première résistance (R2), une deuxième résistance (R3), une troisième résistance (R4) et une quatrième résistance (R5), dans lequel :
la première résistance (R2) est connectée entre la borne d'émetteur du premier transistor PNP (Q1) et la borne d'émetteur du troisième transistor NPN (Q3),
la deuxième résistance (R3) est connectée entre la borne d'émetteur du deuxième transistor NPN (Q2) et la borne d'émetteur du quatrième transistor PNP (Q4),
la troisième résistance (R4) est connectée à la borne de collecteur du troisième transistor NPN (Q3),
la quatrième résistance (R5) est connectée à la borne de collecteur du quatrième transistor PNP (Q4).

3. Circuit amplificateur selon la revendication 1 ou 2, comprenant en outre :
un cinquième transistor PNP (Q41), un sixième transistor PNP (Q42), un septième transistor NPN (Q51) et un huitième transistor NPN (Q52), dans lequel :
une borne une base du cinquième transistor PNP (Q41) est connectée à la borne de collecteur du troisième transistor NPN (Q3),
une borne une base du sixième transistor PNP (Q42) est connectée à une borne d'émetteur du cinquième transistor PNP (Q41),
une borne une base du septième transistor NPN (Q51) est connectée à la borne de collecteur du quatrième transistor PNP (Q4),
une borne une base du huitième transistor NPN (Q52) est connectée à une borne d'émetteur du septième transistor NPN (Q51),
une borne d'émetteur du cinquième transistor PNP (Q41) et une borne d'émetteur du sixième transistor PNP (Q42) sont connectées au potentiel de la première source de courant constant (V1),
une borne d'émetteur du septième transistor NPN (Q51) et une borne d'émetteur du huitième transistor NPN (Q52) sont connectées au potentiel de la seconde source de courant constant (V2),
une borne de collecteur du cinquième transistor PNP (Q41) est connectée au potentiel de terre (GND),
une borne de collecteur du septième transistor NPN (Q51) est connectée au potentiel de terre (GND),
la borne de collecteur du sixième transistor PNP (Q41) et la borne de collecteur du huitième transistor NPN (Q52) sont connectées à la borne de sortie (OUT) du circuit amplificateur (100).

4. Circuit amplificateur selon l'une quelconque des revendications 1 à 3, comprenant en outre :
une résistance de rétroaction négative (R31) conçue pour fournir un signal de rétroaction négative de la borne de sortie (OUT) à la borne de base du premier transistor PNP (Q1) et à la borne de base du deuxième transistor NPN (Q2) par le biais de la résistance de rétroaction négative (R31).

5. Circuit amplificateur selon la revendication 4, comprenant en outre :
un circuit de protection contre les courts-circuits (15),
le circuit de protection contre les courts-circuits (15) comporte un transistor PNP (Q15) connecté entre la borne de base du troisième transistor NPN (Q3) et la borne de base du quatrième transistor PNP (Q4),
le transistor PNP (Q15) peut être commuté d'un état bloqué vers un état passant par un signal externe (PROTECT), de manière que la borne de base du troisième transistor NPN (Q3) et la borne de base du quatrième transistor PNP (Q4) soient mises en court-circuit.
